# EUROPEAN PATENT SPECIFICATION

(11) **EP 4 383 690 B1**
(45) Date of publication and mention of the grant of the patent: **09.12.2026**
(21) Application number: 22856043.9
(22) Date of filing: 18.07.2022
(51) Int. Cl.: H04M 1/02, H05K 1/11, H05K 1/02, H05K 9/00, H05K 1/14

(54) **ELECTRONIC DEVICE COMPRISING INTERPOSER SUBSTRATE**
ELEKTRONISCHE VORRICHTUNG MIT INTERPOSERSUBSTRAT
DISPOSITIF ÉLECTRONIQUE COMPRENANT UN SUBSTRAT D'INTERPOSEUR

(30) Priority: 10.08.2021 KR 20210105341
(43) Date of publication of application: 12.06.2024
(73) Proprietor: Samsung Electronics Co., Ltd., Suwon-si, Gyeonggi-do 16677 (KR)
(72) Inventor: CHUN, Woosung, Suwon-si Gyeonggi-do 16677 (KR); JANG, Hyeyeon, Suwon-si Gyeonggi-do 16677 (KR); JEON, Jeonggoo, Suwon-si Gyeonggi-do 16677 (KR); CHOI, Seungki, Suwon-si Gyeonggi-do 16677 (KR); LEE, Soyoung, Suwon-si Gyeonggi-do 16677 (KR)
(74) Representative: HGF
(86) International application number: PCT/KR2022/010460
(87) International publication number: WO 2023/018042

(56) References cited:
- KR-A- 20200 101 018
- KR-A- 20210 011 144
- KR-A- 20210 017 182
- US-A1- 2009 219 703
- US-A1- 2013 148 322
- US-A1- 2015 146 400
- US-A1- 2020 187 346
- US-A1- 2020 266 562

## Description

### [Technical Field]

The disclosure relates to an electronic device comprising an interposer substrate.

### [Background Art]

Electronic devices may refer to devices that perform specific functions based on embedded programs, such as home appliances, electronic notes, portable multimedia players (PMPs), mobile communication terminals, tablet personal computers (PCs), video/audio devices, desktop/laptop computers, vehicle navigation systems, and so forth. For example, these electronic devices may output stored information in the form of sound or images. With the increasing integration of electronic devices and the common use of ultra-high-speed and large-volume wireless communication, various functions have recently come to be provided in a single electronic device, such as a mobile communication terminal. For example, electronic devices may perform a communication function. Such electronic devices have become compact such that users can conveniently carry and wear them.

US 2020/0266562 A1 discloses an electronic device, including: a first support member including at least one screw-fastening portion; a first printed circuit board (PCB) stacked on the first support member and including at least one screw-fixing portion facing the at least one screw-fastening portion; a second PCB spaced apart from the first PCB, including a first screw guide groove; an interposer disposed between the first PCB and the second PCB electrically connecting them and including a second screw guide groove facing the first screw guide groove; and a second support member stacked on the second PCB and including a screw inlet portion facing the first screw guide groove. The second support member, the first PCB, and the first support member are fixed to each other via a screw inserted through the screw inlet portion.

### [Detailed Description of the Invention]

### [Technical Problem]

According to the invention, as defined in independent claim 1, an electronic device comprises:
a housing comprising a rear plate; an interposer substrate disposed in the housing and comprising a first substrate, a second substrate, an interposer disposed between the first substrate and the second substrate, a ground and a ground via, wherein the second substrate is closer to the rear plate than the first substrate; a conductive support member including a recess and configured to support the first substrate and a third area of the second substrate; and a fastening member partially passing through the second substrate, the fastening member being disposed in the recess, wherein the third area of the second substrate is disposed between a head portion of the fastening member and the support member and comprising the ground and the ground via, the third area adjacent to the fastening member, wherein the fastening member comprises the head portion disposed on the third area of the second substrate and a fastening portion extending from the head portion and disposed in the recess of the support member, wherein the support member comprises a first area configured to support the first substrate, and a second area extending from the first area of the support member through the first substrate and the interposer to support the third area of the second substrate, wherein the head portion is electrically connected to a ground of the third area of the second substrate and the fastening portion is electrically connected to the second area of the support member, wherein the electronic device is configured such that at least a portion of static electricity transferred to the rear plate is transferred to the support member through the ground of the third area and the fastening member.

Optional features are defined in the dependent claims.

### [Brief Description of the Drawings]

FIG. 1 is a block diagram of an electronic device in a network environment according to an embodiment of the disclosure;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5 is a bottom view of an electronic device from which a rear plate is excluded according to an embodiment of the disclosure;
FIG. 6 is an exploded perspective view illustrating an electronic device according to an embodiment of the disclosure;
FIG. 7 is a bottom view illustrating an electronic device according to an embodiment of the disclosure;
FIG. 8 is a cross-sectional view of FIG. 7, taken along line B-B';
FIG. 9 is a view illustrating static electricity introduced into an electronic device according to an embodiment of the disclosure; and
FIGS. 10 and 11 are views illustrating a via structure according to an embodiment of the disclosure.

### [Mode for Carrying out the Invention]

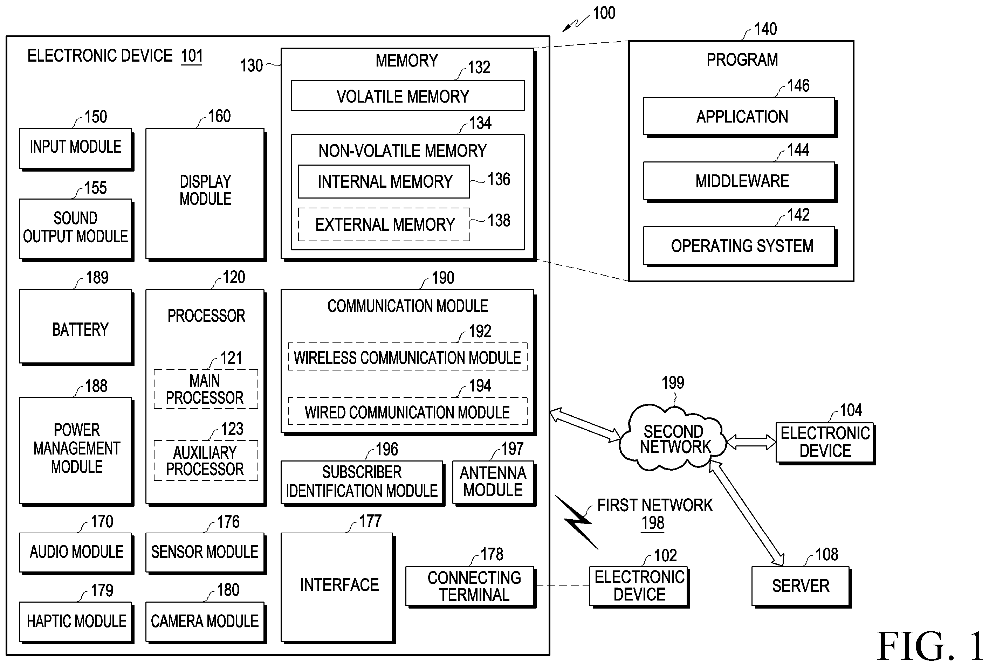

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160). The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in nonvolatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for deep learning model processing. The deep learning model may be generated via machine learning. Such learning may be performed, e.g., by the electronic device 101 where the deep learning model is performed or via a separate server (e.g., the server 108). Learning algorithms may include, but are not limited to, e.g., supervised learning, unsupervised learning, semi-supervised learning, or reinforcement learning. The deep learning model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The deep learning model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the nonvolatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductive body or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. **In** another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

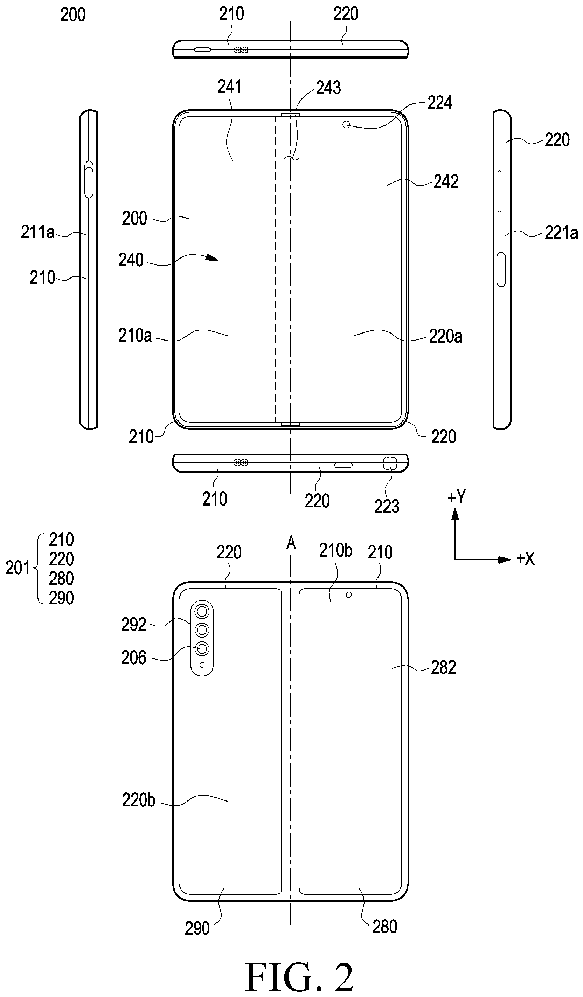

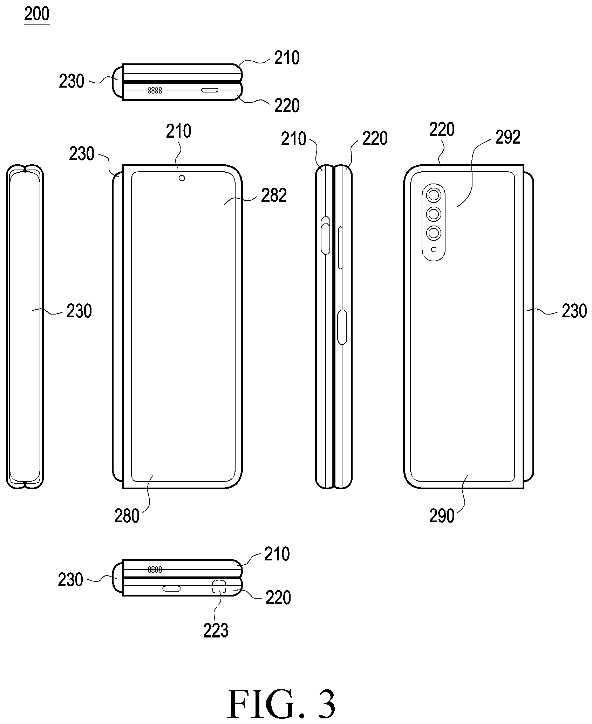

FIG. 2 is a view illustrating an unfolded state of an electronic device according to an embodiment of the disclosure. and FIG. 3 is a view illustrating a folded state of an electronic device according to an embodiment of the disclosure.

Referring to FIGS. 2 and 3, in an embodiment, an electronic device 200 may comprise a housing 201, a hinge cover 230 covering a foldable portion of the housing 201, and a flexible or foldable display 240, (hereinafter simply referred to as "display" 240), disposed in a space formed by the housing 201. According to an embodiment, a surface on which the display 240 is placed is defined as a front surface (e.g., a first surface 210a and a third surface 220a) of the electronic device 200. An opposing surface to the front surface is defined as a rear surface (e.g., a second surface 210b and a fourth surface 220b) of the electronic device 200. Additionally, a surface surrounding the space between the front and rear surfaces is defined as a side surface (e.g., a first side surface 211a and a second side surface 221a) of the electronic device 200.

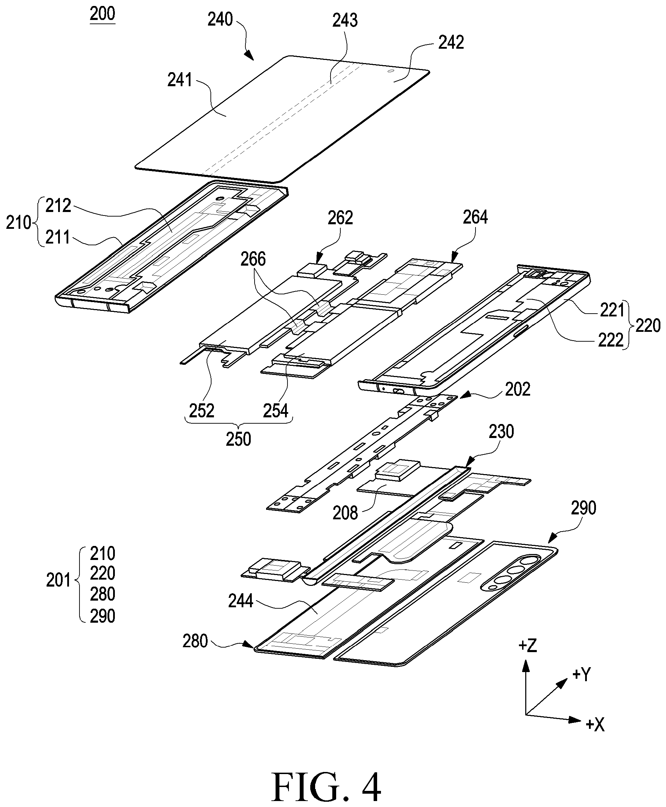

According to an embodiment, the housing 201 may comprise a first housing 210, a second housing 220 rotatably connected to the first housing 210, a first rear cover 280, a second rear cover 290, and a hinge structure (e.g., the hinge structure 202 of FIG. 4). The housing 201 of the electronic device 200 is not limited to the shape and coupling illustrated in FIGS. 2 and 3, and may be implemented in other shapes or by a combination and/or coupling of components. For example, in another embodiment, the first housing 210 and the first rear cover 280 may be integrally formed with each other, and the second housing 220 and the second rear cover 290 may be integrally formed with each other. According to various embodiments, the first housing 210 may be connected to the hinge structure 202 and include a first surface 210a facing in a first direction and a second surface 210b facing in a second direction opposite to the first direction. The second housing 220, which may be connected to the hinge structure 202, may comprise a third surface 220a facing in a third direction and a fourth surface 220b facing in a fourth direction opposite to the third direction, and may rotate about the hinge structure 202 with respect to the first housing 210. Accordingly, the electronic device 200 may turn into a folded state or unfolded state. In the folded state of the electronic device 200, the first surface 210a may face the third surface 220a, and in the unfolded state, the third direction may be the same as the first direction. Hereinafter, unless otherwise specified, the direction will be described based on the unfolded state of the electronic device 200.

According to an embodiment, the first housing 210 and the second housing 220 are disposed on both sides of the folding axis A, and may be overall symmetrical in shape with respect to the folding axis A. As described below, the angle or distance between the first housing 210 and the second housing 220 may be varied depending on whether the electronic device 200 is in the unfolded state, the folded state, or the intermediate state. According to an embodiment, the second housing 220, unlike the first housing 210, may further include a sensor area 224 where various sensors (e.g., a front camera) are disposed, but in other areas, they may have a mutually symmetrical shape. According to an embodiment, the folding axis A may be multiple parallel folding axes, for example, two. In this disclosure, the folding axis A is provided along the longitudinal direction (Y-axis direction) of the electronic device 200, but it is not limited to this orientation. For instance, the electronic device 200 may comprise the folding axis A extending along the width direction (e.g., the X-axis direction).

According to one embodiment, the electronic device 200 may comprise a structure into which a digital pen may be inserted. For instance, a hole 223 into which the digital pen may be inserted may be formed on a side surface of the first housing 210 or a side surface of the second housing 220 of the electronic device 200.

According to various embodiments, the first housing 210 and the second housing 220 may be at least partially formed of a metal or a non-metal material with rigidity selected to support the display 240. At least a portion formed of the metal material may provide a ground plane for the electronic device 200 and may be electrically connected to a ground line formed on a printed circuit board (e.g., the substrate unit 260 in FIG. 4).

According to various embodiments, the sensor area 224 may be formed adjacent to a corner of the second housing 220 and to have a predetermined area. However, the arrangement, shape, and size of the sensor area 224 are not limited to those illustrated. For example, in another embodiment, the sensor area 224 may be provided at a different corner of the second housing 220, in any area between the top corner and the bottom corner or in the first housing 210. In an embodiment, components for performing various functions, embedded in the electronic device 200, may be exposed through the sensor area 224 or one or more openings in the sensor area 224 to the front surface of the electronic device 200. In various embodiments, the components may comprise various kinds of sensors. The sensor may comprise at least one of, for example, a front-facing camera, a receiver, or a proximity sensor.

According to various embodiments, the first rear cover 280 may be disposed on one side of the folding axis A on the rear surface of the electronic device 200 and have, for example, a substantially rectangular periphery, which may be surrounded by the first housing 210. Similarly, the second rear cover 290 may be disposed on the other side of the folding axis A on the rear surface of the electronic device 200 and its periphery may be surrounded by the second housing 220.

According to various embodiments, the first rear cover 280 and the second rear cover 290 may be substantially symmetrical in shape with respect to the folding axis (axis A). However, the first rear cover 280 and the second rear cover 290 may not necessarily be symmetrical in shape. In another embodiment, the electronic device 200 may comprise the first rear cover 280 and the second rear cover 290 in various shapes.

According to various embodiments, the first rear cover 280, the second rear cover 290, the first housing 210, and the second housing 220 may form a space where various components (e.g., a printed circuit board or battery) of the electronic device 200 may be disposed. According to an embodiment, one or more components may be arranged or visually exposed on or through the rear surface of the electronic device 200. For example, at least a portion of a sub display (e.g., the sub display 244 of FIG. 4) may be visually exposed through a first rear surface area 282 of the first rear cover 280. In another embodiment, one or more components or sensors may be visually exposed through a second rear surface area 292 of the second rear cover 290. According to various embodiments, the sensor may comprise a proximity sensor and/or a camera module 206 (e.g., a rear-facing camera).

According to various embodiments, a front camera exposed to the front surface of the electronic device 200 through one or more openings provided in the sensor area 224 or a camera module 206 exposed through a second rear surface area 292 of the second rear cover 290 may comprise one or more lenses, an image sensor, and/or an image signal processor. According to some embodiments, two or more lenses (an infrared (IR) camera, a wide-angle lens, and a telephoto lens) and image sensors may be disposed on one surface of the electronic device 200.

Referring to FIG. 3, the hinge cover 230 may be disposed between the first housing 210 and the second housing 220 to hide internal components (e.g., the hinge structure 202 of FIG. 4). According to an embodiment, the hinge cover 230 may either be covered by a portion of the first housing 210 and a portion of the second housing 220 or exposed to the outside, depending on the state (a flat state or a folded state) of the electronic device 200.

According to an embodiment, as illustrated in FIG. 1, when the electronic device 200 is in the unfolded state, the hinge cover 230 may be hidden, and thus not exposed, by the first housing 210 and the second housing 220. As another example, as illustrated in FIG. 3, when the electronic device 200 is in a folded state (e.g., a fully folded state), the hinge cover 230 may be exposed to the outside between the first housing 210 and the second housing 220. As another example, in an intermediate state in which the first housing 210 and the second housing 220 are folded with a certain angle, the hinge cover 230 may be partially exposed to the outside between the first housing 210 and the second housing 220. In this case, however, the exposed area may be smaller than in the fully folded state. According to an embodiment, the hinge cover 230 may comprise a curved surface.

According to various embodiments, the display 240 may be disposed in a space formed by the housing 201. For example, the display 240 may be seated on a recess formed by the housing 201 and may occupy most of the front surface of the electronic device 200. Accordingly, the front surface of the electronic device 200 may comprise the display 240, and a partial area of the first housing 210 and a partial area of the second housing 220, which are adjacent to the display 240. The rear surface of the electronic device 200 may comprise the first rear cover 280, a partial area of the first housing 210 adjacent to the first rear cover 280, the second rear cover 290, and a partial area of the second housing 220 adjacent to the second rear cover 290.

According to various embodiments, the display 240 may refer to a display, at least a portion of which may be transformed into a flat surface or curved surface. According to an embodiment, the display 240 may comprise a folding area 243, a first display area 241 disposed on one side of the folding area 243(e.g., the left side of the folding area 243 illustrated in FIG. 2), and a second display area 242 disposed on the other side thereof (e.g., the right side of the folding area 243 illustrated in FIG. 2).

However, the area division of the display 240 is exemplary, and the display 240 may be divided into multiple areas (e.g., four or more areas or two areas) depending on the structure or function thereof. For example, in the embodiment illustrated in FIG. 2, the areas of the display 240 may be divided by the folding area 243 or the folding axis (axis A) extending parallel to the y-axis, but in another embodiment, the display 240 may be divided into the areas based on a different folding area (e.g., a folding area parallel to the X-axis) or a different folding axis (e.g., a folding axis parallel to the X-axis). According to an embodiment, the display 240 may be coupled with or disposed adjacent to a touch detection circuit, a pressure sensor capable of measuring the strength (pressure) of touches, and/or a digitizer (not shown) configured to detect a magnetic field-type stylus pen.

According to various embodiments, the first display area 241 and the second display area 242 may have an overall symmetrical shape with respect to the folding area 243. According to an embodiment (not illustrated), unlike the first display area 241, the second display area 242 may comprise a notch cut depending on the presence of the sensor area 224, but in other areas, the second display area 242 may have a symmetrical shape with respect to the first display area 241. In other words, the first display area 241 and the second display area 242 may comprise portions having symmetrical shapes with respect to each other and portions having asymmetrical shapes with respect to each other.

Described below are the operations of the first housing 210 and the second housing 220 and respective areas of the display 240 according to states of the electronic device 200 (e.g., a flat state or an unfolded state and a folded state) are described.

According to various embodiments, when the electronic device 200 is in the unfolded state (flat state) (e.g., FIG. 2), the first housing 210 and the second housing 220 may be disposed to face in the same direction while forming an angle of substantially 180 degrees between them. The surface of the first display area 241 and the surface of the second display area 242 of the display 240 may be oriented 180 degrees to each other while facing in the same direction (e.g., towards the front direction of the electronic device). The folding area 243 may be coplanar with the first display area 241 and the second display area 242.

According to various embodiments, when the electronic device 200 is in the folded state (e.g., FIG. 3), the first housing 210 and the second housing 220 may be disposed to face each other. The surface of the first display area 241 and the surface of the second display area 242 of the display 240 may face each other while forming a small angle (e.g., ranging from 0 degrees to 10 degrees) therebetween. At least a portion of the folding area 243 may have a curved surface with a predetermined curvature.

According to various embodiments, when the electronic device 200 is in an intermediate state (folded state) (e.g., FIG. 3), the first housing 210 and the second housing 220 may be disposed at a certain angle therebetween. The surface of the first display area 241 and the surface of the second display area 242 of the display 240 may form an angle greater than in the folded state but smaller than in the unfolded state. The folding area 243 may have at least partially a curved surface with a predetermined curvature, and in this case, the curvature may be smaller than in a folded state.

FIG. 4 is an exploded perspective view illustrating an electronic device according to various embodiments of the disclosure.

Referring to FIG. 4, the electronic device 200 may comprise a housing 201, a display 240, a hinge structure 202, a battery 250, and a substrate unit 260. The housing 201 may comprise a first housing 210, a second housing 220, a first rear cover 280, and a second rear cover 290.

According to an embodiment, the housing 201 may comprise a first housing 210, a second housing 220, a hinge cover 230, a first rear cover 280, and a second rear cover 290. The configurations of the first housing 210, the second housing 220, the hinge cover 230, the first rear cover 280, and the second rear cover 290 of FIG. 4 may be entirely or partially the same as those of the first housing 210, the second housing 220, the hinge cover 230, the first rear cover 280, and the second rear cover 290 of FIG. 2 and/or FIG. 3.

According to various embodiments, the first housing 210 and the second housing 220 may be assembled together to be coupled to two opposite sides of the hinge structure 202. According to an embodiment, the first housing 210 may comprise a first support area 212 capable of supporting components (e.g., the first circuit board 262 and/or the first battery 252) of the electronic device 200 and a first sidewall 211 surrounding at least a portion of the first support area 212. The first sidewall 211 may comprise a first side surface (e.g., the first side surface 211a of FIG. 2) of the electronic device 200. According to an embodiment, the second housing 220 may comprise a second support area 222 capable of supporting components (e.g., the second circuit board 264 and/or the second battery 254) of the electronic device 200 and a second sidewall 221 surrounding at least a portion of the second support area 222. The second sidewall 221 may comprise a second side surface (e.g., the second side surface 221a of FIG. 2) of the electronic device 200.

According to an embodiment, the display 240 may comprise a first display area 241, a second display area 242, a folding area 243, and a sub display 244. The configurations of the first display area 241, the second display area 242, and the folding area 243 of FIG. 4 may be entirely or partially the same as those of the first display area 241, the second display area 242, and the folding area 243 of FIG. 2 and/or FIG. 3.

According to an embodiment, the sub display 244 may display a screen in a direction different from those of the display areas 241 and 242. For example, the sub display 244 may output a screen in a direction opposite to that of the first display area 241. According to an embodiment, the sub display 244 may be disposed on the first rear cover 280.

According to an embodiment, batteries 250 (e.g., the battery 189 of FIG. 1) may comprise a first battery 252 disposed in the first housing 210 and a second battery 254 disposed in the second housing 220. According to an embodiment, the first battery 252 may be disposed on the first circuit board 262, and the second battery 254 may be disposed on the second circuit board 264.

According to an embodiment, a substrate unit 260 may comprise a first circuit board 262 disposed in the first housing 210 and a second circuit board 264 disposed in the second housing 220. According to an embodiment, the substrate unit 260 may comprise at least one flexible circuit board 266 configured to electrically connect the first circuit board 262 and the second circuit board 264. According to an embodiment, at least a portion of the flexible circuit board 266 may be disposed across the hinge module 202. According to an embodiment, the first circuit board 262 and the second circuit board 264 may be arranged in a space configured by the first housing 210, the second housing 220, the first rear surface cover 280, and the second rear surface cover 290. Components configured to implement various functions of the electronic device 200 may be arranged on the first circuit board 262 and the second circuit board 264.

According to an embodiment, the electronic device 200 may comprise a speaker module 208 (e.g., the audio module 170 of FIG. 1). According to an embodiment, the speaker module 208 may convert an electrical signal into sound. According to an embodiment, the speaker module 208 may be disposed in a space formed by the first housing 210, the second housing 220, the first rear cover 280, and the second rear cover 290.

The detailed description below may comprise an example of a configuration in which a pair of housings (or, referred to as "housings") are rotatably coupled to and by a hinge module (or, referred to as a "hinge structure"). However, it should be noted that such an embodiment does not limit the electronic device according to various embodiments disclosed herein. For example, the electronic device according to various embodiments disclosed herein may comprise three or more housings, "a pair of housings" disclose in an embodiment below may mean "two housings, among the three or more housings, rotatably coupled with each other."

The electronic device 200 illustrated in FIGS. 2 to 4 has an external appearance of a foldable electronic device, but the disclosure is not limited thereto. For example, the illustrated electronic device may take the form of a bar-type, plate-type or rollable electronic device. The terms "rollable electronic device" refers to an electronic device having a portion of which may be at least partially wound, rolled, or accommodated in a housing (e.g., the housing 210 of FIG. 2) as the display (e.g., the display 240 of FIG. 4) may be bent and deformed. The rollable electronic device allows for expansion and use of the screen display area by unfolding the display or exposing a larger area of the display to the outside according to the user's need.

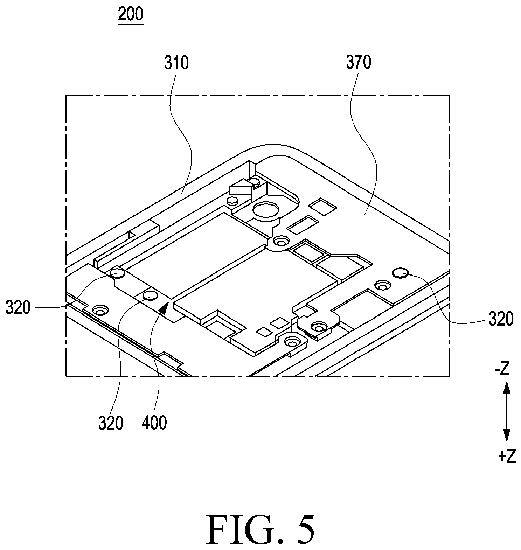

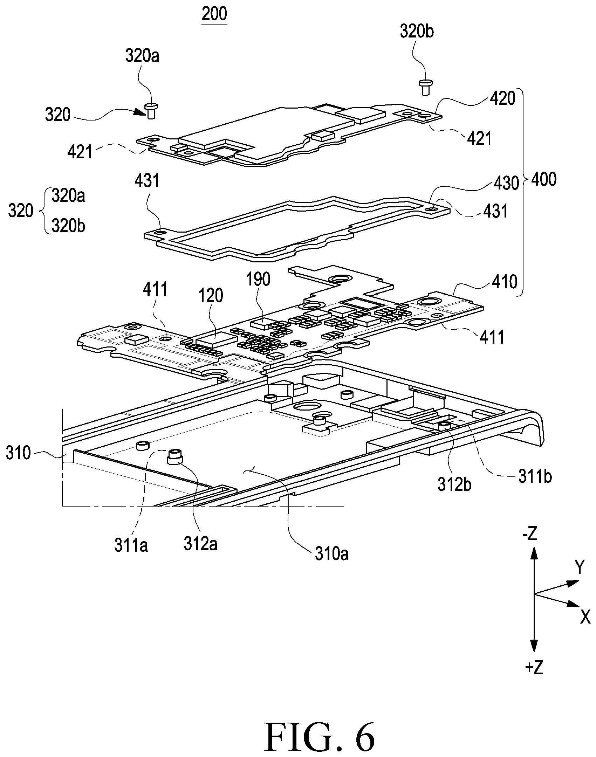

FIG. 5 is a bottom view illustrating an electronic device according to an embodiment of the disclosure, excluding a rear plate (e.g., the rear covers 280 and 290 of FIG. 3). FIG. 6 is an exploded perspective view illustrating an electronic device according to an embodiment of the disclosure.

Referring to FIGS. 5 and 6, the electronic device 200 may comprise a support member 310, a fastening member 320, and an interposer substrate 400. The configurations of the electronic device 200, the support member 310, and the interposer substrate 400 in FIGS. 5 and 6 may be entirely or partially the same as those of the electronic device 200, the bracket 232, and the substrate unit 260 in FIG. 4.

According to an embodiment, the support member 310 may support the interposer substrate 400. For example, the interposer substrate 400 may be disposed on the support member 310. According to an embodiment, the support member 310 may comprise an inner surface 310a facing at least a portion of the interposer substrate 400 and at least one protruding area 312 extending from the inner surface 310a. At least a portion of the interposer substrate 400 may be disposed on the protruding area 312. According to an embodiment, the protruding area 312 may comprise a recess (e.g., the recess 311a or 311b of FIG. 6) capable of accommodating at least a portion of the fastening member 320. According to an embodiment, at least a portion of the support member 310 may be interpreted as a ground for providing a reference potential to the electronic device 200. For example, at least a portion of the support member 310 may comprise a metal or a conductive material. According to an embodiment, at least a portion of the interposer substrate 400 may be covered by the rear case 370. The rear case 370 may protect the interposer substrate 400. According to an embodiment, the rear case 370 may comprise metal (e.g., stainless steel).

According to an embodiment, the protruding area 312 may comprise a plurality of protruding areas 312a and 312b spaced apart from each other. For example, the protruding area 312 may comprise a first protruding area 312a and a second protruding area 312b spaced apart from the first protruding area 312a. The second protruding area 312b may protrude in a direction substantially parallel to the first protruding area 312a.

According to an embodiment, the recesses 311a and 311b may comprise a plurality of recesses 311a and 311b spaced apart from each other. For example, the recesses 311a and 311b may comprise a first recess 311a and a second recess 311b spaced apart from the first recess 311a. The second recess 311b may be a groove or a through hole formed in a direction substantially parallel to the first recess 311a. According to an embodiment, the first recess 311a may be formed in the first protruding area 312a, and the second recess 311b may be formed in the second protruding area 312b.

According to an embodiment, the interposer substrate 400 may comprise a plurality of substrates. According to an embodiment, the interposer substrate 400 may comprise a first substrate 410, a second substrate 420, and an interposer 430 disposed between the first substrate 410 and the second substrate 420. According to an embodiment, the first substrate 410 and the second substrate 420 may be disposed substantially parallel to each other. For example, the first substrate 410 and the second substrate 420 may be positioned along a width (e.g., an XY plane) direction of the electronic device 200. According to an embodiment, each of the first substrate 410 and/or the second substrate 420 may be a substrate including at least one layer. For example, the first substrate 410 may be a master circuit board, and the second substrate 420 may be a slave circuit board. According to an embodiment, the first substrate 410 may accommodate a processor 120 (e.g., the processor 120 of FIG. 1) and/or a communication module 190 (e.g., the communication module 190 of FIG. 1). According to an embodiment, the interposer substrate 400 may be disposed adjacent to a camera module (e.g., the camera module 206 of FIG. 2).

According to an embodiment, the interposer substrate 400 may be connected to the support member 310. According to an embodiment, the interposer substrate 400 may comprise at least one through hole for accommodating the fastening member 320. For example, the first substrate 410 may comprise a first through hole 411, the second substrate 420 may comprise a second through hole 421 corresponding to the first through hole 411, and the interposer 430 may comprise a third through hole 431 corresponding to the first through hole 411 and the second through hole 421. According to an embodiment, the interposer substrate 400 may accommodate electronic components of the electronic device 200. For example, the first substrate 410 or the second substrate 420 may comprise a processor (e.g., the processor 120 of FIG. 1) and/or a communication module (e.g., the communication module 190 of FIG. 1). According to an embodiment, the interposer 430 may be a sidewall surrounding at least a portion between the first substrate 410 and the second substrate 420. For example, the interposer 430 may be formed in a closed curve shape.

According to an embodiment, the electronic device 200 may comprise at least one fastening member 320. According to an embodiment, the fastening member 320 may connect or fasten the interposer substrate 400 to the support member 310. For example, the fastening member 320 may comprise a screw or boss structure. According to an embodiment, the fastening member 320 may be inserted into the through hole 401 of the interposer substrate 400. For example, the fastening member 320 may pass through the first through hole 411 of the first substrate 410, the second through hole 421 of the second substrate 420, and the third through hole 431 of the interposer 430. According to an embodiment, the fastening member 320 may comprise a first fastening member 320a at least partially accommodated in the first recess 311a and a second fastening member 320b at least partially accommodated in the second recess 311b.

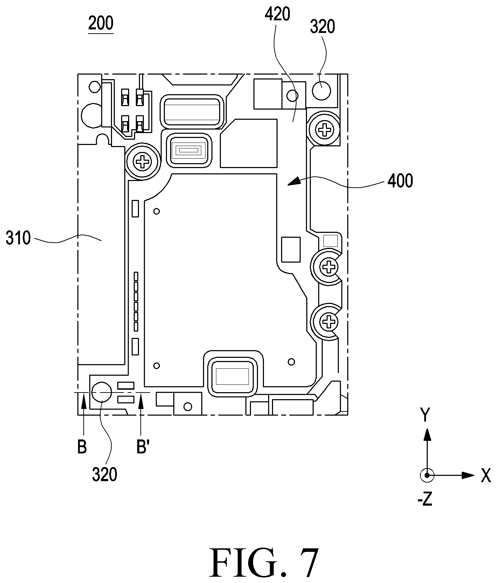

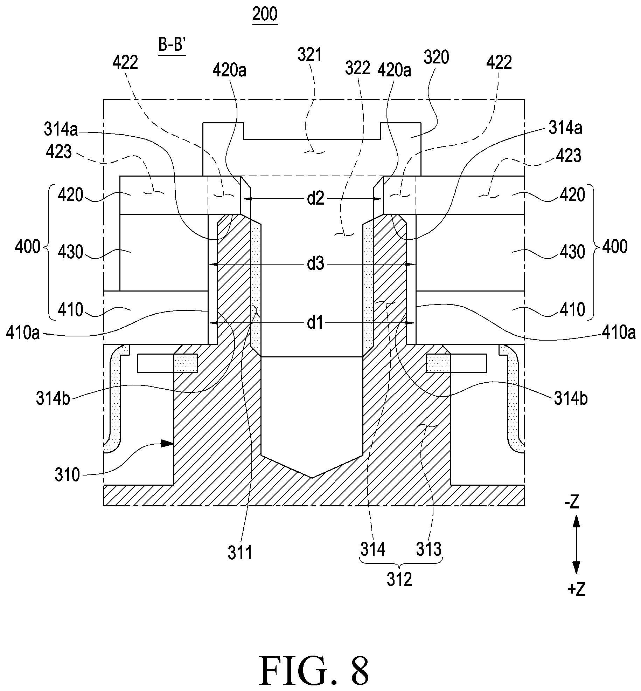

FIG. 7 is a bottom view illustrating an electronic device according to an embodiment of the disclosure. FIG. 8 is a cross-sectional view of FIG. 7, taken along line B-B'.

Referring to FIGS. 7 and 8, the electronic device 200 may comprise a support member 310, a fastening member 320, and an interposer substrate 400.

The configurations of the support member 310, the fastening member 320, and the interposer substrate 400 of FIGS. 7 and 8 may be entirely or partially the same as the configurations of the electronic device 200, the support member 310, the fastening member 320, and the interposer substrate 400 of FIGS. 5 and/or 6.

According to an embodiment, the support member 310 may support the interposer substrate 400. According to an embodiment, the support member 310 may comprise a recess 311 for accommodating the fastening member 320. According to an embodiment, the recess 311 may comprise a protruding structure (e.g., a thread) for guiding insertion of the fastening member 320.

According to an embodiment, the recess 311 may be a groove or a through hole formed in the protruding area 312.

According to an embodiment, the support member 310 may comprise a first area 313 supporting the first substrate 410. The first area 313 may be interpreted as a portion of the protruding area 312 protruding from the inner surface 310a of the support member 310.

According to an embodiment, the support member 310 may comprise a second area 314 for supporting the second substrate 420. The second area 314 may be interpreted as a portion of the protruding area 312 protruding or extending from the first area 313. For example, the second area 314 may protrude from the first area 313 towards the second substrate 420. According to an embodiment, the second area 314 may support the second substrate 420. For example, the second area 314 may comprise an upper surface 314a facing the second substrate 420. According to an embodiment, the second area 314 may be surrounded by the first substrate 410 and the interposer 430. For example, the second area 314 may comprise a side surface 314b surrounded by the first substrate 410 and/or the interposer 430.

According to an embodiment, the fastening member 320 may comprise a head portion 321 and a fastening portion 322 extending from the head portion 321. According to an embodiment, at least a portion of the head portion 321 may be disposed on the second substrate 420. According to an embodiment, the fastening portion 322 may be inserted into the recess 311 of the support member 310. According to an embodiment, the fastening portion 322 may be surrounded by the interposer 430 and the first substrate 410.

According to an embodiment, the second substrate 420 may comprise a third area 422 (e.g., the second area 314) disposed between the head portion 321 and the support member 310, and a fourth area 423 surrounding the third area 423. According to an embodiment, at least a portion of the fourth area 423 may be located above the interposer 430 (e.g., in the -Z direction). According to an embodiment, the third area 422 may be interpreted as a portion of the second substrate 420 pressed by the head portion 321 of the fastening member 320. According to an embodiment, the fourth area 423 may be interpreted as a portion of the second substrate 420 facing the interposer 430.

According to an embodiment, the size of the first substrate 410 may be different from the size of the second substrate 420. For example, the second side surface 420a of the second substrate 420 may be closer to the fastening portion 322 of the fastening member 320 than the first side surface 410a of the first substrate 410. According to an embodiment, the length of the first diameter d1 of the first through hole 411 of the first substrate 410 and/or the length of the third diameter d3 of the third through hole 431 of the interposer 430 may be longer than the length of the second diameter d2 of the second through hole 421 of the second substrate 420. According to an embodiment, the length of the third diameter d3 of the third through hole 431 of the interposer 430 may be substantially the same as the length of the first diameter d1 of the first through hole 411 of the first substrate 410.

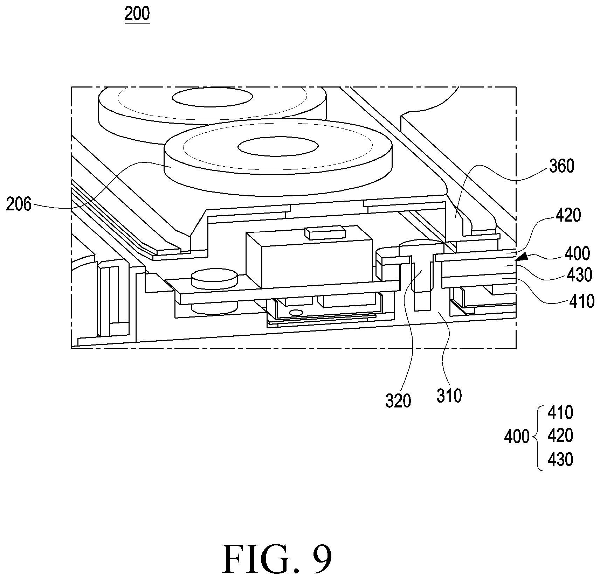

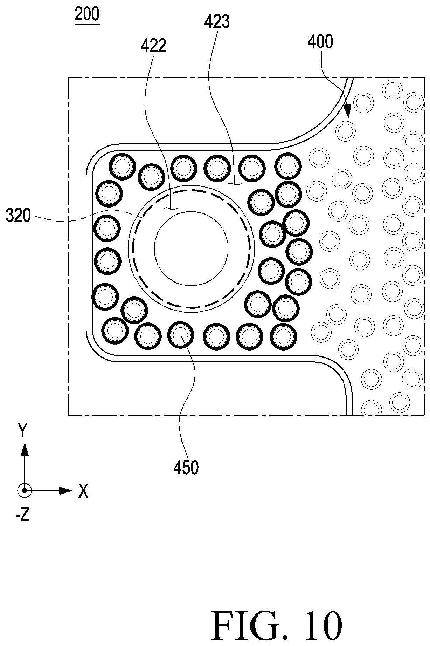

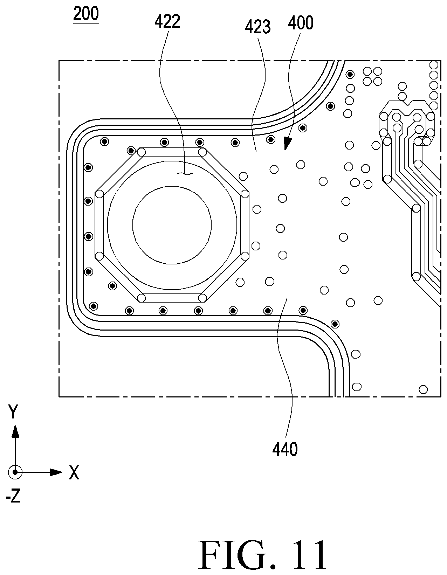

FIG. 9 is a view illustrating static electricity introduced into an electronic device according to an embodiment of the disclosure. FIGS. 10 and 11 are views illustrating a ground via according to an embodiment of the disclosure.

Referring to FIGS. 9 to 11, the electronic device 200 may comprise a support member 310, a fastening member 320, and an interposer substrate 400. The configurations of the support member 310, the fastening member 320, and the interposer substrate 400 of FIGS. 9, 10, and/or 11 may be entirely or partially the same as the configurations of the support member 310, the fastening member 320, and the interposer substrate 400 of FIG. 8.

According to an embodiment, the interposer substrate 400 may comprise a ground 440 and a ground via 450. According to an embodiment, the ground 440 may be located in the first substrate 410 and/or the second substrate 420. The ground 440 may provide a reference potential. According to an embodiment, the ground via 450 may be located in the first substrate 410 and/or the second substrate 420.

According to an embodiment, the ground 440 may be located in the second substrate 420. The ground 440 may guide a movement path of static electricity introduced into the electronic device 200. For example, at least a portion of the static electricity transferred to the second substrate 420 may be transferred to the support member 310 based on the ground 440, which may reduce the static electricity transferred to the electronic component on the second substrate 420. According to an embodiment, the ground 440 may be electrically connected to the third area 422 adjacent to the fastening member (e.g., the fastening member 320 of FIG. 10) and electronic components (not shown) located on the second substrate 420.

According to an embodiment, a plurality of layers of the first substrate 410 may be electrically connected using the ground via 450. A plurality of layers of the second substrate 420 may be electrically connected using the ground via 450. According to an embodiment, the ground 440 may comprise a conductive material (e.g., copper). According to an embodiment, the fastening member 320 and/or the interposer substrate 400 may provide a discharge path of the electronic device 200. For example, the fastening member 320 may transfer power (e.g., surge or static electricity) transferred from the outside of the electronic device 200 to the electronic device 200 to the support member 310 and/or the ground 440 of the interposer substrate 400.

For example, at least a portion of static electricity transferred to the rear plate 360 and/or the camera module 206 of the electronic device 200 may be transferred to the rear plate 360, the second substrate 420, the fastening member 320, the first substrate 410, and/or the support member 310. According to an embodiment, the configuration of the rear plate 360 may be entirely or partially the same as the configuration of the first rear cover 280 and/or the second rear cover 290 of FIG. 4.

According to an embodiment, at least a portion of static electricity transferred to the rear plate 360 of the electronic device 200 may be transferred to the support member 310 via the rear plate 360, the fastening member 320, and the second substrate 420. By reducing the path of the substrate (e.g., the first substrate 410 and/or the second substrate 420) through which the static electricity passes, the length of the electrostatic discharge (ESD) path may be shortened, reducing the impact on the signal line (not shown) and/or the power line (not shown) located in the interposer substrate 400 due to the static electricity.

As used herein, the term "electrically connected" may be defined as a structure that is directly connected (e.g., by contact) or a structure sufficiently adjacent to generate electron movement in response to current.

According to an embodiment, the interposer substrate 400 may be structured to prevent or reduce damage caused by the fastening member 320. For example, the third area 422 (e.g., the third area 422 of FIG. 8) of the second substrate 420, which comes into contact with or faces the fastening member 320, may include a ground via 450 and may not include a signal line (not shown) and/or a power line (not shown). The fourth area 423 of the second substrate 420 may include a ground via, a signal line (not shown), and/or a power line (not shown).

In order to provide a miniaturized electronic device, the electronic device may comprise an interposer substrate on which a plurality of substrates are stacked. According to an embodiment, resin may be used to fix the interposer substrate within the electronic device. However, using resin to fix the interposer substrate within the electronic device may result in damage to the substrate due to the resin infiltration. According to another example, a fastening member may be used to fix the interposer substrate within the electronic device. However, connecting the fastening member to the substrate via a separate mechanical element may reduce the electronic device's mounting space and increase its thickness.

In addition, a surge originating from the outside of the electronic device may be transmitted to the ground of the support member through the plurality of substrates. However, if static electricity is transferred to the ground of the support member through the slave substrate, the interposer, and the master substrate, the length of the electrostatic discharge path may increase, and thus an electrical influence may be applied to the wiring located inside the electronic device.

According to an embodiment of the disclosure, using a fastening member allows for a slim electronic device with increased internal mounting space, while preventing or reducing damage to the substrate.

According to an embodiment of the present disclosure, an electronic device may be provided, which includes a discharge path capable of effectively transmitting a surge originating from outside to the ground.

The disclosure is not limited to the foregoing embodiments, and various modifications or changes may be made thereto without departing from the scope of protection as defined by the appended claims.

According to an embodiment of the disclosure, it is possible to provide an electronic device with increased internal mounting space since a mechanical component for fixing the fastening member to the substrate is not required.

According to an embodiment of the disclosure, it is possible to provide an electronic device with a reduced impact of static electricity on its internal components by shortening the path through which a surge introduced into the electronic device is transmitted to the ground of a support member.

According to an embodiment of the disclosure, an electronic device (e.g., the electronic device 200 of FIG. 2) may comprise a housing (e.g., the housing 210 of FIG. 2); an interposer substrate (e.g., the interposer substrate 400 of FIG. 6) disposed in the housing, including a first substrate (e.g., the first substrate 410 of FIG. 6), a second substrate (e.g., the second substrate 420 of FIG. 6), and an interposer (e.g., the interposer 430 of FIG. 6) disposed between the first substrate and the second substrate; and a support member (e.g., the support member 310 of FIG. 6) which includes a recess (e.g., the recess 311 of FIG. 6) and supports the first substrate and the second substrate, and a fastening member (e.g., the fastening member 320 of FIG. 6) which at least partially passes through the second substrate and is disposed in the recess.

According to an embodiment, the support member may comprise a first area (e.g., the first area 313 of FIG. 8) supporting the first substrate and a second area (e.g., the second area 314 of FIG. 8) extending from the first area and at least partially surrounded by the interposer and the first substrate, and the second area may support the second substrate.

According to an embodiment, the second area may comprise a side surface (e.g., the side surface 314b of FIG. 8) surrounded by the first substrate and the interposer, and an upper surface (e.g., the upper surface 314a of FIG. 8) extending from the outer surface and facing the second substrate.

According to an embodiment, the second area may protrude from the first area towards the second substrate.

According to an embodiment, the fastening member may comprise a head portion (e.g., the head portion 321 of FIG. 8) disposed on the second substrate, and a fastening portion (e.g., the fastening portion 322 of FIG. 8) extending from the head portion and disposed within the recess.

According to an embodiment, the second substrate may comprise a third area (e.g., the third area 422 of FIG. 8) disposed between the head portion and the support member, and a fourth area (e.g., the fourth area 423 of FIG. 8) surrounding the third area and facing the interposer.

According to an embodiment, the third area may comprise a ground via (e.g., the ground via 450 of FIG. 10), and the fourth area may comprise the ground via, a signal line, and a power line.

According to an embodiment, the interposer substrate may comprise a through hole (e.g., the through hole 411, 421, or 431 of FIG. 6) configured to accommodate the support member and the fastening member.

According to an embodiment, the first substrate may comprise a first through hole (e.g., the first through hole 411 of FIG. 6) having a first diameter (e.g., the first diameter d1 of FIG. 8), and the second substrate may comprise a second through hole (e.g., the second through hole 421 of FIG. 6) having a second diameter smaller than the first diameter.

According to an embodiment, the housing may comprise a rear plate (e.g., the rear plate 360 of FIG. 9), and the electronic device may further comprise a camera module (e.g., the camera module 206 of FIG. 9) facing at least a portion of the rear plate.

According to an embodiment, at least a portion of static electricity transferred from the outside of the electronic device may be configured to be transferred to the support member through the rear plate, the second substrate, and the fastening member.

According to an embodiment, the recess may comprise a first recess (e.g., the first recess 311a of FIG. 6) and a second recess (e.g., 311b of FIG. 6) spaced apart from the first recess, and the fastening member may comprise a first fastening member (e.g., the first fastening member 320a of FIG. 6) at least partially disposed in the first recess and a second fastening member (e.g., the second fastening member 320b of FIG. 6) at least partially disposed in the second recess.

According to an embodiment, at least a portion of the interposer may be formed in a closed curve shape.

According to an embodiment, the fastening member may comprise a screw.

According to an embodiment, the electronic device may further comprise a battery (e.g., the battery 250 of FIG. 4) disposed in the housing and a processor (e.g., the processor 120 of FIG. 6) disposed on the interposer substrate.

According to an embodiment of the disclosure, an electronic device (e.g., the electronic device 200 of FIG. 2) may comprise a housing (e.g., the housing 210 of FIG. 2); an interposer substrate (e.g., the interposer substrate 400 of FIG. 6) disposed in the housing and including a first substrate (e.g., the first substrate 410 of FIG. 6), a second substrate (e.g., the second substrate 420 of FIG. 6), and an interposer (e.g., the interposer 430 of FIG. 6) surrounding at least a portion between the first substrate and the second substrate; a protruding area (e.g., the protruding area 312 of FIG. 8) including a first area (e.g., the first area 313 of FIG. 8) supporting the first substrate, and a second area (e.g., the second area 314 of FIG. 8) extending from the first area and supporting the second substrate; a support member (e.g., the support member 310 of FIG. 8) including a recess (e.g., the recess 311 of FIG. 8) surrounded by the protruding area, and a fastening member (e.g., the fastening member 320 of FIG. 8) including a head portion (e.g., the head portion 321 of FIG. 8) disposed on the second substrate and a fastening portion (e.g., the fastening portion 322 of FIG. 8) extending from the head portion and disposed in the recess.

According to an embodiment, the second area may comprise a side surface (e.g., the side surface 314b of FIG. 8) surrounded by the first substrate and the interposer, and an upper surface (e.g., the upper surface 314a of FIG. 8) extending from the side surface and facing the second substrate.

According to an embodiment, the first substrate may comprise a first through hole (e.g., the first through hole 411 of FIG. 6) having a first diameter (e.g., the first diameter d1 of FIG. 8), and the second substrate may comprise a second through hole (e.g., the second through hole 421 of FIG. 6) having a second diameter (e.g., the second diameter d2 of FIG. 8) smaller than the first diameter.

According to an embodiment, the fastening portion may be surrounded by the interposer and the first substrate.

According to an embodiment, the housing may comprise a rear plate (e.g., the rear plate 360 of FIG. 9), and at least a portion of static electricity transferred from the outside of the electronic device may be configured to be transferred to the support member through the rear plate, the second substrate, and the fastening member.

It will be apparent to one of ordinary skill in the art that the electronic device including the interposer substrate according to the disclosure as described above is not limited to the above-described embodiments and those shown in the drawings, and various changes, modifications, or alterations may be made thereto without departing from the scope of the present invention.

## Claims

1. An electronic device, comprising:
a housing (210) comprising a rear plate (360);
an interposer substrate (400) disposed in the housing and comprising a first substrate (410), a second substrate (420), an interposer (430) disposed between the first substrate and the second substrate, a ground (440) and a ground via (450), wherein the second substrate is closer to the rear plate than the first substrate;
a conductive support member (310) including a recess (311a, 311b) and configured to support the first substrate and a third area (422) of the second substrate; and
a fastening member (320) partially passing through the second substrate, the fastening member being disposed in the recess,
wherein the third area of the second substrate is disposed between a head portion (321) of the fastening member and the support member and comprising the ground and the ground via, the third area adjacent to the fastening member,
wherein the fastening member comprises the head portion (321) disposed on the third area of the second substrate and a fastening portion (322) extending from the head portion and disposed in the recess of the support member,
wherein the support member comprises a first area (313) configured to support the first substrate, and a second area (314) extending from the first area of the support member through the first substrate and the interposer to support the third area of the second substrate,
wherein the head portion is electrically connected to a ground of the third area of the second substrate and the fastening portion is electrically connected to the second area of the support member,
wherein the electronic device is configured such that at least a portion of static electricity transferred to the rear plate is transferred to the support member (310) through the ground of the third area and the fastening member.

2. The electronic device (101) of claim 1,
wherein the second area (314) of the support member is at least partially surrounded by the interposer (430) and the first substrate.

3. The electronic device (101) of claim 2, wherein the second area (314) of the support member comprises:
a side surface (211a) surrounded by the first substrate (410) and the interposer (430), and
an upper surface (314a) extending from the side surface and facing the second substrate (420).

4. The electronic device (101) of claim 2 or 3, wherein the second area of the support member (314) protrudes from the first area (313) towards the second substrate (420).

5. The electronic device (101) of any one of the preceding claims, wherein the fastening portion is surrounded by the interposer (430) and the first substrate.

6. The electronic device (101) of any one of the preceding claims, wherein the second substrate (420) comprises: a fourth area (423) surrounding the third area (422) and facing the interposer (430).

7. The electronic device (101) of claim 6, wherein, the fourth area (423) comprises the ground via, a signal line, and a power line.

8. The electronic device (101) of any one of the preceding claims, wherein the interposer substrate (400) comprises a through hole (411, 421) configured to accommodate the support member (310) and the fastening member (320).

9. The electronic device (101) of any one of the preceding claims, wherein,
the first substrate (410) comprises a first through hole (411) having a first diameter, and
the second substrate (420) comprises a second through hole (421) having a second diameter smaller than the first diameter.

10. The electronic device (101) of any one of the preceding claims,
wherein the electronic device further comprises a camera module (206) facing at least a portion of the rear plate.

11. The electronic device (101) of any one of the preceding claims, wherein the recess (311a, 311b) comprises a first recess (311a) and a second recess (311b) spaced apart from the first recess, and
wherein the fastening member (320) comprises:
a first fastening member (320a) at least partially disposed in the first recess (311a), and
a second fastening member (320b) at least partially disposed in the second recess (311b).

12. The electronic device (101) of any one of the preceding claims, wherein at least a portion of the interposer (430) is formed in a closed curve shape.

13. The electronic device (101) of any one of the preceding claims, wherein the fastening member (320) comprises a screw.

14. The electronic device (101) of any one of the preceding claims, further comprising:
a battery (250) disposed in the housing (210); and
a processor (120) disposed on the interposer substrate (400).

## Patentansprüche

1. Elektronische Vorrichtung, umfassend:
ein Gehäuse (210), das eine hintere Platte (360) umfasst;
ein Interposersubstrat (400), das in dem Gehäuse angeordnet ist und ein erstes Substrat (410), ein zweites Substrat (420), einen Interposer (430), der zwischen dem ersten Substrat und dem zweiten Substrat angeordnet ist, eine Masse (440) und eine Masse-Durchkontaktierung (450) umfasst, wobei das zweite Substrat näher an der hinteren Platte liegt als das erste Substrat;
ein leitfähiges Stützelement (310), das eine Aussparung (311a, 311b) beinhaltet und dazu konfiguriert ist, das erste Substrat und einen dritten Bereich (422) des zweiten Substrats zu stützen; und
ein Befestigungselement (320), das teilweise durch das zweite Substrat verläuft, wobei das Befestigungselement in der Aussparung angeordnet ist,
wobei der dritte Bereich des zweiten Substrats zwischen einem Kopfteil (321) des Befestigungselements und dem Stützelement angeordnet ist und die Masse und die Masse-Durchkontaktierung umfasst, wobei der dritte Bereich an das Befestigungselement angrenzt,
wobei das Befestigungselement den Kopfteil (321), der auf dem dritten Bereich des zweiten Substrats angeordnet ist, und einen Befestigungsteil (322) umfasst, der sich von dem Kopfteil erstreckt und in der Aussparung des Stützelements angeordnet ist,
wobei das Stützelement einen ersten Bereich (313), der dazu konfiguriert ist, das erste Substrat zu stützen, und einen zweiten Bereich (314) umfasst, der sich von dem ersten Bereich des Stützelements durch das erste Substrat und den Interposer erstreckt, um den dritten Bereich des zweiten Substrats zu stützen,
wobei der Kopfteil elektrisch mit einer Masse des dritten Bereichs des zweiten Substrats verbunden ist und der Befestigungsteil elektrisch mit dem zweiten Bereich des Stützelements verbunden ist,
wobei die elektronische Vorrichtung so konfiguriert ist, dass zumindest ein Teil der auf die hinteren Platte übertragenen statischen Elektrizität durch die Masse des dritten Bereichs und das Befestigungselement auf das Stützelement (310) übertragen wird.

2. Elektronische Vorrichtung (101) nach Anspruch 1,
wobei der zweite Bereich (314) des Stützelements zumindest teilweise von dem Interposer (430) und dem ersten Substrat umgeben ist.

3. Elektronische Vorrichtung (101) nach Anspruch 2, wobei der zweite Bereich (314) des Stützelements Folgendes umfasst:
eine Seitenoberfläche (211a), die von dem ersten Substrat (410) und dem Interposer (430) umgeben ist, und
eine obere Oberfläche (314a), die sich von der Seitenfläche erstreckt und dem zweiten Substrat (420) zugewandt ist.

4. Elektronische Vorrichtung (101) nach Anspruch 2 oder 3, wobei der zweite Bereich des Stützelements (314) von dem ersten Bereich (313) in Richtung des zweiten Substrats (420) vorsteht.

5. Elektronische Vorrichtung (101) nach einem der vorhergehenden Ansprüche, wobei der Befestigungsteil von dem Interposer (430) und dem ersten Substrat umgeben ist.

6. Elektronische Vorrichtung (101) nach einem der vorhergehenden Ansprüche, wobei das zweite Substrat (420) Folgendes umfasst: einen vierten Bereich (423), der den dritten Bereich (422) umgibt und dem Interposer (430) zugewandt ist.

7. Elektronische Vorrichtung (101) nach Anspruch 6, wobei der vierte Bereich (423) die Masse-Durchkontaktierung, eine Signalleitung und eine Stromleitung umfasst.

8. Elektronische Vorrichtung (101) nach einem der vorhergehenden Ansprüche, wobei das Interposersubstrat (400) ein Durchgangsloch (411, 421) umfasst, das dazu konfiguriert ist, das Stützelement (310) und das Befestigungselement (320) aufzunehmen.

9. Elektronische Vorrichtung (101) nach einem der vorhergehenden Ansprüche, wobei
das erste Substrat (410) ein erstes Durchgangsloch (411) mit einem ersten Durchmesser umfasst und das zweite Substrat (420) ein zweites Durchgangsloch (421) mit einem zweiten Durchmesser umfasst, der kleiner als der erste Durchmesser ist.

10. Elektronische Vorrichtung (101) nach einem der vorhergehenden Ansprüche,
wobei die elektronische Vorrichtung ferner ein Kameramodul (206) umfasst, das zumindest einem Teil der hinteren Platte zugewandt ist.

11. Elektronische Vorrichtung (101) nach einem der vorhergehenden Ansprüche, wobei die Aussparung (311a, 311b) eine erste Aussparung (311a) und eine zweite Aussparung (311b) umfasst, die von der ersten Aussparung beabstandet ist, und
wobei das Befestigungselement (320) Folgendes umfasst:
ein erstes Befestigungselement (320a), das zumindest teilweise in der ersten Aussparung (311a) angeordnet ist, und
ein zweites Befestigungselement (320b), das zumindest teilweise in der zweiten Aussparung (311b) angeordnet ist.

12. Elektronische Vorrichtung (101) nach einem der vorhergehenden Ansprüche, wobei zumindest ein Teil des Interposers (430) in einer geschlossenen Kurvenform ausgebildet ist.

13. Elektronische Vorrichtung (101) nach einem der vorhergehenden Ansprüche, wobei das Befestigungselement (320) eine Schraube umfasst.

14. Elektronische Vorrichtung (101) nach einem der vorhergehenden Ansprüche, ferner umfassend:
eine Batterie (250), die in dem Gehäuse (210) angeordnet ist; und
einen Prozessor (120), der auf dem Interposersubstrat (400) angeordnet ist.

## Revendications

1. Dispositif électronique, comprenant :
un boîtier (210) comprenant une plaque arrière (360) ;
un substrat d'interposeur (400) disposé dans le boîtier et comprenant un premier substrat (410), un second substrat (420), un interposeur (430) disposé entre le premier substrat et le second substrat, une masse (440) et un via (450) de masse, ledit second substrat étant plus proche de la plaque arrière que le premier substrat ;
un élément de support conducteur (310) comprenant un évidement (311a, 311b) et conçu pour supporter le premier substrat et une troisième zone (422) du second substrat ; et
un élément de fixation (320) passant partiellement à travers le second substrat, l'élément de fixation étant disposé dans l'évidement,
ladite troisième zone du second substrat étant disposée entre une partie de tête (321) de l'élément de fixation et l'élément de support et comprenant la masse et le via de masse, la troisième zone étant adjacente à l'élément de fixation,
ledit élément de fixation comprenant la partie de tête (321) disposée sur la troisième zone du second substrat et une partie de fixation (322) s'étendant à partir de la partie de tête et disposée dans l'évidement de l'élément de support,
ledit élément de support comprenant une première zone (313) conçue pour supporter le premier substrat, et une deuxième zone (314) s'étendant à partir de la première zone de l'élément de support à travers le premier substrat et l'interposeur pour supporter la troisième zone du second substrat,
ladite partie de tête étant raccordée électriquement à une masse de la troisième zone du second substrat et ladite partie de fixation étant raccordée électriquement à la deuxième zone de l'élément de support,
ledit dispositif électronique étant conçu de sorte qu'au moins une partie de l'électricité statique transférée à la plaque arrière soit transférée à l'élément de support (310) par l'intermédiaire de la masse de la troisième zone et de l'élément de fixation.

2. Dispositif électronique (101) de la revendication 1,
ladite deuxième zone (314) de l'élément de support étant au moins partiellement entourée par l'interposeur (430) et le premier substrat.

3. Dispositif électronique (101) de la revendication 2, ladite deuxième zone (314) de l'élément de support comprenant :
une surface latérale (211a) entourée par le premier substrat (410) et l'interposeur (430), et
une surface supérieure (314a) s'étendant à partir de la surface latérale et faisant face au second substrat (420).

4. Dispositif électronique (101) de la revendication 2 ou 3, ladite deuxième zone de l'élément de support (314) faisant saillie à partir de la première zone (313) en direction du second substrat (420).

5. Dispositif électronique (101) de l'une quelconque des revendications précédentes, ladite partie de fixation étant entourée par l'interposeur (430) et le premier substrat.

6. Dispositif électronique (101) de l'une quelconque des revendications précédentes, ledit second substrat (420) comprenant : une quatrième zone (423) entourant la troisième zone (422) et faisant face à l'interposeur (430).

7. Dispositif électronique (101) de la revendication 6, ladite quatrième zone (423) comprenant le via de masse, une ligne de signal et une ligne d'alimentation.

8. Dispositif électronique (101) de l'une quelconque des revendications précédentes, ledit substrat d'interposeur (400) comprenant un trou traversant (411, 421) conçu pour loger l'élément de support (310) et l'élément de fixation (320).

9. Dispositif électronique (101) de l'une quelconque des revendications précédentes,
ledit premier substrat (410) comprenant un premier trou traversant (411) possédant un premier diamètre, et
ledit second substrat (420) comprenant un second trou traversant (421) possédant un second diamètre inférieur au premier diamètre.

10. Dispositif électronique (101) de l'une quelconque des revendications précédentes,
ledit dispositif électronique comprenant en outre un module de caméra (206) faisant face à au moins une partie de la plaque arrière.

11. Dispositif électronique (101) de l'une quelconque des revendications précédentes, ledit évidement (311a, 311b) comprenant un premier évidement (311a) et un second évidement (311b) espacé du premier évidement, et
ledit élément de fixation (320) comprenant :
un premier élément de fixation (320a) disposé au moins partiellement dans le premier évidement (311a), et
un second élément de fixation (320b) disposé au moins partiellement dans le second évidement (311b).

12. Dispositif électronique (101) de l'une quelconque des revendications précédentes, au moins une partie de l'interposeur (430) étant formée selon une forme de courbe fermée.

13. Dispositif électronique (101) de l'une quelconque des revendications précédentes, ledit élément de fixation (320) comprenant une vis.

14. Dispositif électronique (101) de l'une quelconque des revendications précédentes, comprenant en outre :
une batterie (250) disposée dans le boîtier (210) ; et
un processeur (120) disposé sur le substrat d'interposeur (400).
